# EUROPEAN PATENT SPECIFICATION

(11) **EP 2 439 783 B1**
(45) Date of publication and mention of the grant of the patent: **24.08.2016**
(21) Application number: 10783390.7
(22) Date of filing: 02.06.2010
(51) Int. Cl.: H01L 31/042, B32B 27/20, B32B 27/32, H01L 31/048, H01L 31/052, H01L 31/054

(54) **SEALING FILM FOR SOLAR CELL, AND SOLAR CELL UTILIZING SAME**
DICHTUNGSFILM FÜR EINE SOLARZELLE UND SOLARZELLE DAMIT
FILM D'ÉTANCHÉITÉ POUR CELLULE SOLAIRE ET CELLULE SOLAIRE L'UTILISANT

(30) Priority: 05.06.2009 JP 2009135695
(43) Date of publication of application: 11.04.2012
(73) Proprietor: Bridgestone Corporation, Tokyo 104-8340 (JP)
(72) Inventor: INOUE Yoshihiko, Yokohama-shi Kanagawa 244-8510 (JP); KATAOKA Hisataka, Yokohama-shi Kanagawa 244-8510 (JP)
(74) Representative: Oxley, Robin John George
(86) International application number: PCT/JP2010/059317
(87) International publication number: WO 2010/140608

(56) References cited:
- EP-A1- 2 056 356
- WO-A1-2008/023722
- JP-A- 2006 036 875
- JP-A- 2006 036 876
- US-A1- 2002 129 848

## Description

### Technical Field

The present invention as claimed in claim 1 relates to a solar cell sealing film consisting chiefly of ethylene-polar monomer copolymer, containing a colorant that is titanium white (titanium dioxide) which is used in a backside of a solar cell.

### Background of the Art

A solar cell (solar cell module) has been widely employed as a device directly converting solar energy into electric energy from the viewpoints of the effective use of natural resources and the prevention of environmental pollution, and is further developed.

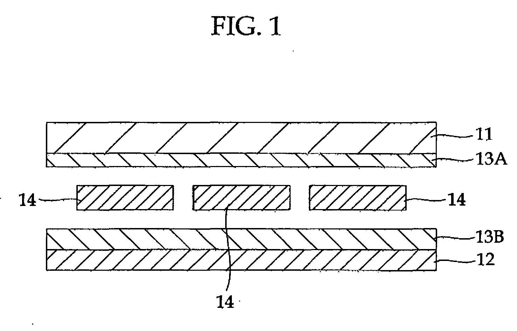

As shown in Fig. 1, the solar cell can be prepared by superposing a transparent front side (light-receiving side) protection material 11 such as a glass plate, a front side (light-receiving side) sealing film 13A, photovoltaic elements (e.g., photovoltaic elements made of silicon) 14, a backside sealing film 13B and a backside protection material (backside covering member) 12, in this order, and degassing them under reduced pressure, and then heating the front side sealing film 13A and the backside sealing film 13B under application of pressure to crosslink or cure the films, whereby they are bonded and combined. In the solar cell, a plurality of photovoltaic elements 14 are connected with each other in order to generate high electric output. Hence it is necessary to ensure high insulation properties between the photovoltaic elements 14, and therefore the front side sealing film 13A and the backside sealing film 13B are also required to have high insulation properties.

Further, thin-film solar cells such as a thin-film silicon type solar cell, a thin-film amorphous silicon type solar cell and a copper indium selenide (CIS) type solar cell are also developed. In the cells, a photovoltaic element layer such as a semiconductor layer is formed on a transparent plate such as a glass plate or polyimide plate by chemical vapor deposition and a sealing film is superposed on it.

As a sealing film for a solar cell (solar cell sealing film), a film made of ethylene-polar monomer copolymer such as ethylene-vinyl acetate copolymer (EVA) or ethylene-ethylacrylate copolymer (EEA) is heretofore used. The ethylene-vinyl acetate copolymer is preferably used because it has low cost and high transparency. The ethylene-polar monomer copolymer film is highly crosslinked by using a crosslinker such as an organic peroxide in addition to ethylene-polar monomer copolymer to enhance the crosslink density to improve the film strength or durability.

It is strongly desired that light incident upon the solar cell is effectively taken into the photovoltaic elements of the solar cell as much as possible and focused to the photovoltaic elements, in order to enhance electric generation efficiency of the solar cell. From this viewpoint, a front side sealing layer containing a compound having an alkylene oxide group is developed to show higher transparency (Patent Document 1). Further a backside sealing layer containing a colorant such as titanium white (titanium dioxide) is developed. In more detail, since the sealing film is colored with white, it can effectively utilize the reflected light (Patent Document 2).

### Prior Art Documents

### Patent Document

Patent Document 1: JP(TOKKAI) 2008-53379 A
Patent Document 2: JP(TOKKAIHEI) 6(1994)-177412 A

### Summary of the Invention

### Problem to be solved by the Invention

The sealing layer containing colorant that is titanium white (titanium dioxide) may be sometimes reduced in electrical insulation properties due to the colorant. The reduction of electrical insulation properties brings about leak of electric current to reduce the electric generation efficiency of the solar cell.

Thus, the object of the present invention is to provide a solar cell backside sealing film comprising ethylene-polar monomer copolymer as a chief ingredient, a crosslinker giving crosslinked structure and titanium dioxide as a colorant, which is free from reduction of electrical insulation properties. Further the object of the present invention is to provide a solar cell using the sealing film.

### Means for Solving Problem

The above-mentioned object can be attained by a solar cell sealing film comprising ethylene-polar monomer copolymer, a crosslinker and titanium dioxide as a colorant,
which further contains a (meth)acrylate compound represented by the following formula (I): 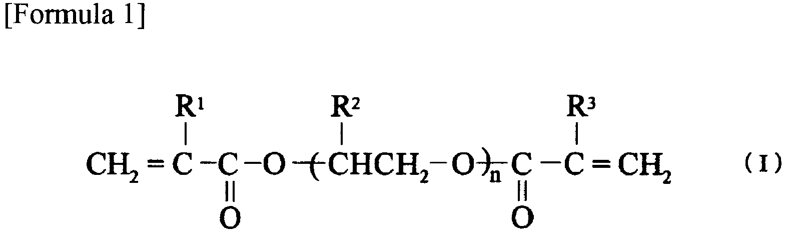 in which R¹, R² and R³ represent H or CH₃, and n is an integer of 9 to 14. The addition of the (meth)acrylate compound makes it possible to suppress the reduction of electrical insulation properties generated by the addition of the colorant.

The preferred embodiments of the solar cell sealing film according to the present invention are described as follows:
(1) R² of the formula (I) represents H.
(2) The (meth)acrylate compound is contained in an amount of 0.1 to 1.0 part by weight based on 100 parts by weight of the ethylene-polar monomer copolymer.
(3) The crosslinker is organic peroxide.
(4) The ethylene-polar monomer copolymer is ethylene-vinyl acetate copolymer.

Further the present invention is provided by a solar cell comprising a transparent front side protection material, a backside protection material and photovoltaic elements sealed therebetween by a sealing film, these being combined with each other by crosslinking of the sealing film,
wherein at least the sealing film between the backside protection material and photovoltaic elements is the solar cell sealing film as defined in any of claims 1 to 5.

In the solar cell of the present invention, the side (light receiving side) which is exposed to light for photovoltaic elements of a solar cell is referred to as "front side", while the side opposite to the light receiving side of photovoltaic elements of a solar cell is referred to as "backside".

### Effect of the Invention

Though the solar cell sealing film according to the present invention comprises ethylene-polar monomer copolymer as a chief ingredient and a crosslinker giving crosslinked structure, and further contains titanium dioxide as a colorant for effective utilization of reflected light which is required for a backside sealing film, the sealing film is suppressed in the reduction of electrical insulation properties. Hence, the use of the solar cell sealing film of the invention as a backside sealing film makes it possible to provide a solar cell which can effectively utilize reflected light and which has excellent electrical insulation properties and enhanced electric generation efficiency.

### Brief Description of the Drawings

[Fig. 1]
Fig. 1 is a schematic section view of a conventional solar cell.

### Mode for Carrying out the Invention

The solar cell sealing film of the present invention includes ethylene-polar monomer copolymer, a crosslinker and titanium dioxide as a colorant, and further contains a (meth)acrylate compound represented by the following formula (I): 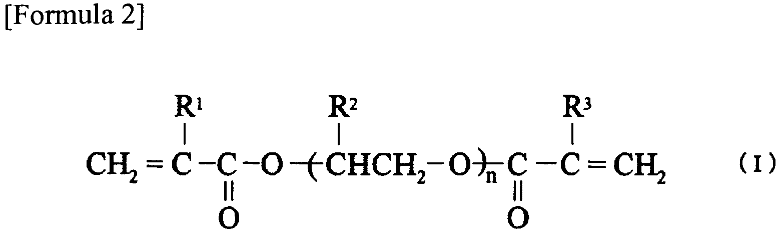 in which R¹, R² and R³ represent H or CH₃, and n is an integer of 9 to 14. In the invention, the (meth)acrylate means acrylate or methacrylate. The addition of the (meth)acrylate compound of the formula (I) (also referred as to the compound I) makes it possible to suppress the reduction of electrical insulation properties generated by the addition of the colorant. The cause of the reduction is not apparent. However, the following mechanism is considered.

In more detail, the compound I has a given number of ethyleneoxy groups and two carbon-carbon double bonds (-C=C-) derived from (meth)acryloyl groups. Therefore the compound I in the sealing film is firmly incorporated into the crosslinked structure of ethylene-polar monomer copolymer. It is considered that the reduction of electrical insulation properties generated by the addition of the colorant occurs by ion movement by colorant particles having electric charges. However, in case the compound I is present in the sealing film, the colorant particles can be captured by the ethyleneoxy groups of the compound I. The compound I is firmly incorporated in the crosslinked structure, whereby the ion movement in the sealing film can be restricted and the reduction of electrical insulation properties can be suppressed.

The solar cell sealing film of the invention is explained in detail below.

### ((Meth)acrylate compound of the formula (I))

The compound I of the invention has 9 to 14 of ethyleneoxy groups (-CH₂CH₂- wherein R² is H)), or 9 to 14 of propyleneoxy groups (-CH(CH₃)CH₂- wherein R² is CH₃)), and further (meth)acryloyl groups or (meth)acryloyloxy groups at the both ends of the molecule, as shown the formula I. In the invention, the (meth)acryloyl means acryloyl or methacryloyl, while the (meth)acryloyloxy means acryloyloxy or methacryloyloxy.

As mentioned above, it is considered that the function that the ethyleneoxy or propyleneoxy groups are ionically-bonded to the colorant particles is to suppress the reduction of electrical insulation properties. The ethyleneoxy group (wherein R² is H) is preferred because it has reduced steric hindrance and hence is capable of easily capturing the colorant particles. In the case the "n" that is the number of alkyleneoxy group is less than 9, the compound I does not have sufficient capacity capturing the colorant particles and therefore cannot suppress the reduction of electrical insulation properties. In contrast, in case the case the "n" is more than 14, the compound I shows reduction of compatibility with ethylene-polar monomer copolymer to bring about lowering of processing properties. Moreover, the compound I is incorporated in the crosslinked structure due to two carbon-carbon double bonds (-C=C-) of (meth)acryloyl groups at its both sides, the crosslinked structure being formed by the ethylene-polar monomer copolymer being crossliked by the crosslinker. In contrast, a compound having one (meth)acryloyl group only at one side is not sufficiently incorporated in the crosslinked structure, and hence cannot fully suppress the ion movement of colorant particles not to bring about sufficient reduction of electrical insulation properties.

Examples of the compound I include polyethylene glycol di(meth)acrylate having 9 to 14 of ethyleneoxy groups such as nonaethylene glycol di(meth)acrylate, decaethylene glycol di(meth)acrylate, undecaethylene glycol di(meth)acrylate, dodecaethylene glycol di(meth)acrylate, tridecaethylene glycol di(meth)acrylate and tetradecaethylene glycol di(meth)acrylate; and polypropylene glycol di(meth)acrylate having 9 to 14 of propyleneoxy groups such as nonapropylene glycol di(meth)acrylate, decapropylene glycol di(meth)acrylate, undecapropylene glycol di(meth)acrylate, dodecapropylene glycol di(meth)acrylate, tridecapropylene glycol di(meth)acrylate and tetradecapropylene glycol di(meth)acrylate. These compounds can be employed singly or in combination of two or more kinds.

Of these compounds, polyethylene glycol di(meth)acrylate having 9 to 14 of ethyleneoxy groups is preferred. Particularly preferred are nonaethylene glycol di(meth)acrylate and tetradecaethylene glycol di(meth)acrylate.

The solar cell sealing film of the present invention contains the (meth)acrylate compound preferably in an amount of 0.1 to 1.0 part by weight, more preferably 0.1 to 0.5 part by weight, based on 100 parts by weight of the ethylene-polar monomer copolymer. The use of the compound in too small amount does not occasionally bring about sufficient reduction of electrical insulation properties, whereas the use of the compound in excessive amount does not occasionally bring about the inhibition of function of the crosslinker to reduce the crosslinked density and the reduction of the processing properties such as difficulty in kneading.

### (Ethylene-polar monomer copolymer)

Examples of the polar monomer of the ethylene-polar monomer copolymer of the invention include unsaturated carboxylic acids, salts thereof, esters thereof and amides thereof, vinyl esters and carbon monoxide. Examples of the unsaturated carboxylic acids include acrylic acid, methacrylic acid, fumaric acid, itaconic acid, monomethyl maleate, monoethyl maleate, maleic anhydride and itaconic anhydride; metal salts of these unsaturated carboxylic acids, examples of the metal including monovalent metals such as lithium, sodium and potassium, and polyvalent metals such as magnesium, calcium and zinc. Examples of the unsaturated carboxylic acid esters include methyl acrylate, ethyl acrylate, isopropyl acrylate, isobutyl acrylate, n-butyl acrylate, isooctyl acrylate, methyl methacrylate, ethyl methacrylate, isobutyl methacrylate and dimethyl maleate. Examples of the vinyl esters include vinyl acetate and vinyl propionate. Further there can be mentioned carbon monoxide and sulfur dioxide. These compounds can be employed singly or in combination of two or more kinds.

Examples of the ethylene-polar monomer copolymer include ethylene-unsaturated carboxylic acid copolymers such as ethylene-acrylic acid copolymer and ethylene-methacrylic acid copolymer; ionomers of ethylene-unsaturated carboxylic acid copolymers in which a part or all of the carboxyl groups are neutralized with the above-mentioned metal; ethylene-unsaturated carboxylic ester copolymers such as ethylene-methyl acrylate copolymer, ethylene-ethyl acrylate copolymer, ethylene-methyl methacrylate copolymer, ethylene-isobutyl acrylate copolymer and ethylene-n-butyl acrylate copolymer; ethylene-unsaturated carboxylic ester-unsaturated carboxylic acid copolymers such as ethylene-isobutyl acrylate-methacrylic acid copolymer and ethylene-n-butyl acrylate-methacrylic acid copolymer; ionomers of ethylene-unsaturated carboxylic ester-unsaturated carboxylic acid copolymer in which a part or all of the carboxyl groups are neutralized with the above-mentioned metal; and ethylene-vinyl ester copolymer such as ethylene-vinyl acetate copolymer.

The ethylene-polar monomer copolymer has preferably Melt Flow Rate according to JIS K 7210 of not more than 35 g/10min., especially 3 to 6 g/10min. The use of a solar cell sealing film made of the ethylene-polar monomer copolymer having Melt Flow Rate specified as above make it possible to suppress the phenomenon that the sealing film spreads out of a substrate due to its melt or position gap in a heating and pressurizing procedure of the sealing step for preparing a solar cell.

The value of the Melt Flow Rate is determined under the conditions of temperature of 190°C and load of 21.18N according to JIS K 7210.

Ethylene-vinyl ester copolymer (also referred as to EVA) is especially preferred as the ethylene-polar monomer copolymer. The use of this copolymer makes it possible to prepare a solar cell sealing film having low price, transparency and excellent flexibility, the transparency influencing reflectivity of the sealing film containing titanium dioxide as a colorant of the invention.

In the sealing film, the content of vinyl acetate (recurring unit) in ethylene-vinyl acetate copolymer preferably is in the range of 20 to 35% by weight, more preferably 22 to 30% by weight especially 24 to 28% by weight based on 100 parts by weight of ethylene-vinyl acetate copolymer. When the content of vinyl acetate is less than 20% by weight, the sealing film crosslinked and cured at high temperature does not occasionally show sufficiently high transparency. On the other hand, when the content of vinyl acetate is more than 35 % by weight, the EVA is apt to form carboxylic acid, alcohol or amine acetic acid to generate bubbles at the interface between the sealing film and the protective material.

Though the sealing film of the invention comprises ethylene-polar monomer copolymer, the film, if necessary, may secondarily contain polyvinyl acetal resin such as polyvinyl formal, polyvinyl butyral (PVB resin) or modified PVB, or vinyl chloride resin. The PVB resin is preferred.

### (Colorant)

The colorant used in the invention enables the effective utilization of the reflected light in electric generation of a solar cell. White colorants are preferred in view of light reflectivity, and titanium white (titanium dioxide) is used because of high colorability. The solar cell sealing film of the present invention contains the colorant preferably in an amount of 1 to 10 parts by weight, more preferably 2 to 5 part by weight, based on 100 parts by weight of the ethylene-polar monomer copolymer.

### (Crosslinker)

The crosslinker of the invention enables the formation of the crosslinked structure of ethylene-polar monomer copolymer. An organic peroxide or photopolymerization initiator is preferably used as the crosslinker. The organic peroxide is more preferably used because the resultant sealing film is improved in temperature dependencies in adhesion, transparency, humidity resistance and penetration resistance.

Any organic peroxides that can be decomposed at a temperature of not less than 100°C to generate radical(s) can be employed as the above-mentioned organic peroxide. The organic peroxide is selected in the consideration of film-forming temperature, conditions for preparing the composition, curing (bonding) temperature, heat resistance of body to be bonded, storage stability. Especially, preferred are those having a decomposition temperature of not less than 70°C in a half-life of 10 hours.

From the viewpoint of resin processing temperature and storage stability, examples of the organic peroxides include benzoyl peroxide-type cure agents, tert-hexyl peroxypyvalate, tert-butyl peroxypyvalate, 3,5,5-trimethyl hexanoyl peroxide, di-n-octanoyl peroxide, lauroyl peroxide, stearoyl peroxide, 1,1,3,3-tetramethylbutylperoxy-2-ethyl hexanoate, succinic acid peroxide, 2,5-dimethyl-2,5-di(tert-butylperoxy)hexane, 2,5-dimethyl-2,5-di(2-ethylhaxanoylperoxy)hexane, 1-cyclohexyl-1-methylethylperoxy-2-ethyl hexanoate, tert-hexylperoxy-2-ethyl hexanoate, 4-methylbenzoyl peroxide, tert-butylperoxy-2-ethyl hexanoate, m-toluoyl + benzoyl peroxide, 1,1-bis(tert-butylperoxy)-2-methylcyclohexanate, 1,1-bis(tert-hexylperoxy)-3,3,5-trimethylcyclohexane, 1,1-bis(tert-hexylperoxy)cyclohexanate, 1,1-bis(tert-butylperoxy)-3,3,5-trimethylcyclohexane 1,1-bis(tert-butylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butylperoxy maleic acid, tert-butylperoxy-3,3,5-trimethyl hexane, tert-butyl peroxylaurate, 2,5-dimethyl-2,5-di(methylbenzoylperoxy)hexane, tert-butylperoxyisopropyl monocarbonate, tert-butylperoxy-2-ethylhexyl monocarbonate, tert-hexyl peroxybenzoate, and 2,5-di-methyl-2,5-di(benzoylperoxy)hexane.

As the benzoyl peroxide-type cure agents, any organic peroxides that can be decomposed at a temperature of not less than 70°C to generate radical(s) can be employed. Especially, preferred are those having a decomposition temperature of not less than 50°C in a half-life of 10 hours. The benzoyl peroxide-type cure agents is selected in the consideration of conditions for preparing the composition, film-forming temperature, curing (bonding) temperature, heat resistance of body to be bonded, storage stability. Examples of the benzoyl peroxide-type cure agents include benzoyl peroxide, 2,5-dimethylhexyl-2,5-bisperoxy benzoate, p-chlorobenzoyl peroxide, m-toluoyl peroxide, 2,4-dicyclobenzoyl peroxide, tert-butylperoxy benzoate. The benzoyl peroxide-type cure agents can be employed singly or in combination of two or more kinds.

As the organic peroxide, particularly preferred are 2,5-di-methyl-2,5-di(t-butylperoxy)hexane and 1.1-bis(tert-hexylperoxy)-3,3,5-trimethylcyclohexane, which bring about a solar cell sealing film having excellent electrical insulation properties.

The content of the crosslinker in the sealing film preferably is in the range of 0.1 to 2 parts by weight, in particular 0.2 to 1.5 parts by weight based on 100 parts by weight of ethylene-polar monomer copolymer. When the content of the cross-linking agent is less, the insulation properties of the sealing film are apt to be reduced. When the content of the cross-linking agent is excessive, the compatibility of the crosslinker with the copolymer is apt to be reduced.

Any known photopolymerization initiators can be employed as the crosslinker. Preferred are initiators having good storage stability after addition thereof.

Examples of the photopolymerization initiators include acetophenone type initiators such as 2-hydroxy-2-methyl-1-phenylpropane-1-on, 1-hydroxycyclohexylphenylketone, 2-methyl-1-[4-(methylthio)phenyl]-2-morphorino-propane-1-on; benzoin type initiators such as benzylmethylketal; and the benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1] -hydroxycyclohexylphenylketone, 2-methyl-1-[4-(methylthio)phenyl]-2-morphorinopropane-1-on and benzophenone. These photopolymerization initiators can be employed, if necessary, together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds.

The photopolymerization initiator is preferably contained in the composition in the range of 0.5 to 5.0 parts by weight based on 100 parts by weight of ethylene-polar monomer copolymer.

### (Crosslinking auxiliary)

The solar cell sealing film of the invention preferably contains, if necessary, crosslinking auxiliary. The crosslinking auxiliary enables the enhancement of gel fraction of ethylene-polar monomer copolymer and the improvement of adhesion and durability of the sealing film.

The crosslinking auxiliary is generally preferably used in the range of not more than 10 parts by weight, preferably 0.1 to 5 parts by weight, more preferably 0.1 to 2.5 parts by weight based on 100 parts by weight of ethylene-polar monomer copolymer.

Examples of the crosslinking auxiliaries (compounds having radical polymerizable groups as functional groups) include trifunctional crosslinking auxiliaries such as triallyl cyanurate and triallyl isocyanurate, and mono- or bifunctional crosslinking auxiliaries of (meth)acryl esters (e.g., NK Ester, etc.). Triallyl cyanurate and triallyl isocyanurate are preferred, especially triallyl isocyanurate.

### (Adhesion improver)

The solar cell sealing film of the invention preferably has excellent adhesion from the viewpoint of sealing performance within a solar cell. Therefore the sealing film preferably contains an adhesion improver. As the adhesion improver, a silane-coupling agent can be employed, whereby a solar cell sealing film having excellent adhesion can be obtained.

Examples of the silane coupling agents include γ-chloropropylmethoxysilane, vinyltriethoxysilane, vinyl-tris(β-methoxyethoxy)silane, γ-methacryloxypropyltrimethoxysilane, vinylacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-γ-aminopropyltrimethoxysilane. The silane coupling agent can be employed singly or in combination of two or more kinds. Particularly, γ-methacryloxypropyltrimethoxysilane is preferred.

The silane-coupling agent is preferably contained in an amount of 0.1 to 0.7 part by weight, especially 0.3 to 0.65 part by weight, based on 100 parts by weight of ethylene-polar monomer copolymer.

### (Others)

The sealing film of the invention can contain, if necessary, various additives such as plasticizers, acryloxy group-containing compounds and/or methacryloxy group-containing compounds other than the compound I of the invention, and/or epoxy group-containing compounds, for improvement or adjustment of various properties of the resultant film (e.g., mechanical strength, adhesive property (adhesion), optical characteristics such as transparency, heat resistance, light-resistance, cross-linking rate).

Though any plasticizers can be used with not restricted, esters of polybasic acids and esters of polyhydric alcohols are generally used. Examples of the esters include dioctyl phthalate, dihexyl adipate, triethylene glycol-di-2-ethylbutylate, butyl sebacate, tetraethylene glycol diheptanoate, triethylene glycol diperalgonate. The plasticizer may be used singly or in combination of two or more kinds. The plasticizer is preferably contained in an amount of not more than 5 parts by weight based on 100 parts by weight of ethylene-polar monomer copolymer.

Examples of the acryloxy and methacryloxy group containing compounds include generally derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, 3-chloro-2-hydroxypropyl group. Example of the amide includes diacetone acrylamide. Further, examples of the esters include esters of acrylic acid or methacrylic acid with polyhydric alcohol such as ethylene glycol, triethylene glycol, polypropylene glycol, polyethylene glycol, trimethylol propane or pentaerythritol.

Examples of the epoxy group containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)₅glycidyl ether, p-tert-butylphenyl glycidyl ether, diglycidyl adipate, diglycidyl phthalate, glycidyl methacrylate and butyl glycidyl ether.

The content of the acryloxy group-containing compounds, the methacryloxy group-containing compounds or the epoxy group-containing compounds is preferably used in the range of 0.5 to 5.0 parts by weight, especially 1.0 to 4.0 parts by weight based on 100 parts by weight of ethylene-polar monomer copolymer.

The solar cell sealing film may further contain an ultraviolet absorbent, a photostabilizer and an antioxidant additionally. The use of ultraviolet absorbent suppresses deterioration of ethylene-polar monomer copolymer by irradiation of light whereby a sealing film for solar cell suffers from yellowing.

Examples of the ultraviolet absorbents, though are not particularly restricted, include benzophenone-type ultraviolet absorbents such as 2-hydroxy-4-methoxybenzophenone, 2-hydroxy-4-n-dodecyloxybenzophenone, 2,4-dihydroxybenzophenone, 2,2'-dihydroxy-4-methoxybenzophenone, and 2-hydroxy-4-n-octoxybenzophenone. The content of the benzophenone-type ultraviolet absorbent preferably is in the range of 0.01 to 5 parts by weight based on 100 parts by weight of ethylene-polar monomer copolymer.

The use of photostabilizer also suppresses deterioration of ethylene-polar monomer copolymer by irradiation of light whereby a sealing film for solar cell suffers from yellowing.

A hindered amine photostabilizer can be preferably used as the photostabilizer. Examples of the photostabilizers include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD,and CHIMASSORB 944LD (each manufactured by Ciba Specialty Chemicals Co., Ltd.), and UV-3034 (each manufactured by B. F. Goodrich). The photostabilizer can be each used singly, or in combination of two or more kinds. The content of the photostabilizer preferably is in the range of 0.01 to 5 parts by weight based on 100 parts by weight of ethylene-polar monomer copolymer.

Examples of the antioxidants include hindered phenol-type antioxidants such as N,N'-hexan-1,6-diyl-bis[3-(3,5-di-tert-butyl-4-hydroxyphenyl) propionamide], phosphorus-type heat stabilizers, lactone-type heat stabilizers, vitamin E-type heat stabilizers and sulfur-type heat stabilizers.

### (Process for the preparation of a solar cell sealing film)

The solar cell sealing film can be prepared according to known processes. The solar cell sealing film can be prepared, for example, by mixing the above-mentioned materials by known method using a Super Mixer (fast fluid mixer) or a roll mill, and molding the resultant composition under application of pressure and heating by using conventional extrusion molding or calendar molding (calendaring) to prepare a product in the form of sheet. Otherwise, the solar cell sealing film can be prepared by dissolving the above-mentioned composition in a solvent to form a solution and applying the solution onto an appropriate support by an appropriate coater and drying it to form a coated film (product in the form of sheet). The heating temperature in the film-formation preferably is such range that the crosslinker is not reacted or scarcely reacted. For example, the heating temperature preferably is in the range of 50 to 90°C, especially 40 to 80°C such that the crosslinker is not decomposed. The thickness of the solar cell sealing film, though is not particularly restricted, preferably is in the range of 50µm to 2mm.

### (Solar cell, and process for the preparation thereof)

The structure of the solar cell is not particularly restricted, as long as the solar cell sealing film according to the invention is used as a backside sealing film between a backside protection material and photovoltaic elements (sealing film opposite to a light-receiving side). For example, there can be mentioned the structure comprising a transparent light-receiving side protection material, a backside protection material and photovoltaic elements sealed therebetween with the sealing films of the invention, which is obtained by curing the sealing films and combining them.

The solar cell is preferably prepared in order to sufficiently seal photovoltaic elements as follows. In more detail, a transparent front side protection material 11, a front side sealing film 13A, photovoltaic elements 14, a backside sealing film 13B (the solar cell sealing film of the invention) and a backside protection material 12 are superposed to prepare a laminate and the laminate is crosslinked or cured according to a conventional process including heating and pressuring steps, as shown in Fig. 1. The solar cell sealing film of the invention containing titanium dioxide as a colorant is not suitable for the front side sealing film (light-receiving side sealing film), and therefore a conventional solar cell sealing film containing no colorant is used for the front side sealing film. For example, a solar cell sealing film having high transparency described in Patent Document 1 can be used.

The solar cell of the invention using the solar cell sealing film of the invention as a backside sealing film shows high electric generation efficiency because it can effectively utilize reflected light and further suppress the reduction of electrical insulation properties.

In more detail, the laminate can be bonded, for example, under the application of pressure and heat by using a vacuum laminator in the conditions of temperature of 135 to 180°C (preferably 140 to 180°C, especially 155 to 180°C), degassing time period of 0.1 to 5min., pressing pressure of 0.1 to 1.5kg/cm² and pressing time period of 5 to 15min. This application of pressure and heat enables the ethylene-polar monomer copolymer contained in the front side sealing film 13A and the backside sealing film 13B to crosslink, whereby the photovoltaic elements 14, the transparent front side protection material 11 and the backside protection material 12 are combined through the front side sealing film 13A and the backside sealing film 13B to seal the photovoltaic elements 14.

The solar cell sealing film of the invention can be used in not only solar cells using photovoltaic elements composed of single or poly crystal-type silicon crystal, but also thin-film solar cells such as thin-film silicon-type solar cell, thin-film amorphous silicon-type solar cell and copper selenide-induim (CIS)-type solar cell. Examples of the structures of the thin-film solar cells include the structure that the solar cell sealing film of the invention and a backside protection material are superposed on a thin-film solar cell element which is formed by chemical phase deposition method on a transparent front (light-receiving) side protection material such as a glass plate, a polyimide substrate or a fluoro resin transparent substrate, and the resultant laminate is bonded and united; or the structure that a transparent font side protection material, the front side sealing film, a thin-film solar cell element, the backside sealing film of the invention and a backside protection material are superposed in this order and the resultant laminate is bonded and united.

The transparent front side protection material 11 used in the solar cell of the invention generally is a glass plate such as silicate glass. A thickness of the glass plate is generally in the range of 0.1 to 10 mm, preferably 0. 3 to 5 mm. The glass plate is tempered in heat or chemical resistance.

The backside protection material 12 of the invention generally is a plastic film (e.g., PET), but preferably fluorinated polyethylene film (especially a film that fluorinated polyethylene film/Al/ fluorinated polyethylene film are laminated in this order) from the viewpoint of heat resistance and heat and humidity resistance.

The solar cell (including a thin-film solar cell) of the invention is characterized in use of the specific sealing films provided on a backside. Therefore as materials used in components other than the sealing film (i.e., transparent front side protection material, backside protection material, front side sealing film and photovoltaic elements, etc.), those used in a known solar cell can be used, which are not particularly restricted.

### EXAMPLES

The invention is illustrated in detail using the following Examples.

### [Examples 1-10, Comparison Examples 1-7, Reference Examples 1 and 2]

The materials of the formulation set forth in Table 1 and Table 2 were introduced into a roll mill and kneaded at 70°C to prepare a composition for a solar cell sealing film. The composition for a solar cell sealing film was subjected to calendaring processing and cooled to prepare a solar cell sealing film (thickness: 0.6 mm).

The resultant solar cell sealing film was cut to prepare a sample having a size of 100mm×100mm, which was temporarily bonded under pressure by a vacuum laminator at 90°C, and then heated in an oven at 155°C for 30min. to be crosslinked to gel fraction of 90%.

### (1) Volume intrinsic resistivity

Volume intrinsic resistivity (LogΩ•cm) of each of the resultant samples is measured by using a high resistivity meter (Hiresta UP available from Mitsubishi Chemical Corporation) in atmosphere of 60°C. Based on the value of volume intrinsic resistivity of the sealing film (Reference Example 1) containing no titanium dioxide, a sample having a value of volume intrinsic resistivity of not less than 13.0 is regarded as acceptance.

### (2) Processing property

Ease of kneading of the composition by the roll mill is evaluated as follows.
○: Kneading can be conducted without problem.
Δ: Kneading can be conducted with a little difficulty.
×: Kneading can be difficultly conducted.

**[Table 1]**

| | | Ex.1 | Ex.2 | Ex.3 | Ex.4 | Ex. 5 | Ex. 6 | Ex. 7 | Ex. 8 | Ex. 9 | Ex.10 | Ref. Ex. 1 | Ref. Ex.2 |
|---|---|---|---|---|---|---|---|---|---|---|---|---|---|
| Formulation (wt. parts) | EVA^{*1} | 100 | 100 | 100 | 100 | 100 | 100 | 100 | 100 | 100 | 100 | 100 | 100 |
| | Crosslinker^{*2} | 0.6 | 0.6 | 0.6 | 0.6 | 0.6 | 0.6 | 0.6 | 0.6 | 0.6 | 0.6 | 0.6 | 0.6 |
| | Crosslinking auxiliary^{*3} | 1.0 | 1.0 | 1.0 | 1.0 | 1.0 | 1.0 | 1.0 | 1.0 | 1.0 | 1.0 | 1.0 | 1.0 |
| | Additives^{*4} | 0.5 | 0.5 | 0.5 | 0.5 | 0.5 | 0.5 | 0.5 | 0.5 | 0.5 | 0.5 | 0.5 | 0.5 |
| | Colorant (titanium dioxide) | 4.5 | 4.5 | 4.5 | 4.5 | 4.5 | 4.5 | 4.5 | 4.5 | 4.5 | 4.0 | 0 | 0 |
| | (Meth)acrylate compd (1)^{*5} | 0.1 | 0.2 | 0.5 | 0.8 | 1.0 | 1.5 | -- | -- | -- | 0.1 | -- | 0.1 |
| | (Meth)acrylate compd (2)^{*6} | -- | -- | -- | -- | -- | -- | 0.1 | 0.2 | 0.5 | -- | -- | -- |
| | (Meth)acrylate compd (3)^{*7} | -- | -- | -- | -- | -- | -- | -- | -- | -- | -- | -- | -- |
| | (Meth)acrylate compd (4)^{*8} | -- | -- | -- | -- | -- | -- | -- | -- | -- | -- | -- | -- |
| | (Meth)acrylate compd (5)^{*9} | -- | -- | -- | -- | -- | -- | -- | -- | -- | -- | -- | -- |
| Evaluation | Volume intrinsic resistivity | 13.1 | 13.2 | 13.5 | 13.6 | 13.7 | 13.9 | 13.3 | 13.4 | 13.5 | 13.1 | 13.1 | 13.4 |
| | Processing property | ○ | ○ | ○ | ○ | ○ | Δ | ○ | ○ | ○ | ○ | ○ | ○ |

| | | | | | | | | | | | | | |
|---|---|---|---|---|---|---|---|---|---|---|---|---|---|
| Note) *1: Content of vinyl acetate based on 100 wt. parts of EVA: 25 wt. parts *2: 1,1-bis(t-hexylperoxy)-3,3,5-trimethylcyclohexane *3: Ttriallyl isocyanurate *4: γ-Methacryloxypropyl trimethoxy silane *5: Nonaethylene glycol dimethacrylate (Lightester 9EG; KYOEISHA CHEMICAL Co., Ltd.) *6: Tetradecaethylene glycol dimethacrylate (Lightester 14EG; KYOEISHA CHEMICAL Co., Ltd.) *7: Triethylene glycol dimethacrylate (Lightester 3EG; KYOEISHA CHEMICAL Co., Ltd.) *8: 1,9-nonanediol dimethacrylate (Lightester 1,9ND; KYOEISHA CHEMICAL Co., Ltd.) *9: Methoxtypolyethylene glycol acrylate (Lightacrylate 130A; KYOEISHA CHEMICAL Co., Ltd.) Ex.: Example Ref. Ex.: Reference Example Compd.: Compound | | | | | | | | | | | | | |

**[Table 2]**

| | | Co. Ex.1 | Co. Ex.2 | Co. Ex.3 | Co. Ex.4 | Co. Ex. 5 | Co. Ex. 6 | Co. Ex. 7 |
|---|---|---|---|---|---|---|---|---|
| Formulation (wt. parts) | EVA^{*1} | 100 | 100 | 100 | 100 | 100 | 100 | 100 |
| | Crosslinker^{*2} | 0.6 | 0.6 | 0.6 | 0.6 | 0.6 | 0.6 | 0.6 |
| | Crosslinking auxillary^{*3} | 1.0 | 1.0 | 1.0 | 1.0 | 1.0 | 1.0 | 1.0 |
| | Additives ^{*4} | 0.5 | 0.5 | 0.5 | 0.5 | 0.5 | 0.5 | 0.5 |
| | Colorant (titanium dioxide) | 4.5 | 4.5 | 4.5 | 4.5 | 4.5 | 4.5 | 4.5 |
| | (Meth)acrylate compd (1)^{*5} | -- | -- | -- | -- | -- | -- | -- |
| | (Meth)acrylate compd (2)^{*6} | -- | -- | -- | -- | -- | -- | -- |
| | (Meth)acrylate compd (3)^{*7} | -- | 0.1 | 0.2 | -- | -- | -- | -- |
| | (Meth)acrylate compd (4)^{*8} | -- | -- | -- | 0.1 | 0.2 | 1.0 | -- |
| | (Meth)acrylate compd (5)^{*9} | -- | -- | -- | -- | -- | -- | 0.5 |
| Evaluation | Volume intrinsic resistivity | 12.6 | 12.5 | 12.6 | 12.6 | 12.6 | 12.6 | 12.6 |
| | Processing property | ○ | ○ | ○ | ○ | ○ | × | ○ |

| | | | | | | | | |
|---|---|---|---|---|---|---|---|---|
| Note) * 1-*9: As described in Table 1] Co. Ex.: Comparison Example | | | | | | | | |

### (Evaluation result)

Volume intrinsic resistivity of each of the resultant samples is indicated in Table 1 and Table 2. Solar cell sealing films containing 0.1 to 1.5 parts by weight of (meth)acrylate compounds represented by the formula (I) wherein R¹ and R³ are CH₃, R² is H, and n is 9 or 4, which are described in Examples 1-10, are evaluated. As a result, the films of all Examples 1-10 are in comparable in volume intrinsic resistivity to the film of Reference Example 1 containing no colorant (titanium dioxide) to show volume intrinsic resistivity of not less than 13.0, which is acceptance. In contrast, the film of Comparison Example 1 containing no (meth)acrylate compound shows extremely reduced volume intrinsic resistivity. By comparison of the difference between volume intrinsic resistivities of Comparison Example 1 and Example 1 (containing colorant) with the difference between between volume intrinsic resistivities of Reference Examples 1 and 2 (containing no colorant), the difference between the resistivities of Comparison Example 1 and Example 1 is larger than the difference between the resistivities of Reference Examples 1 and 2, and hence it is perceived that the sealing films containing colorant show remarkably effect in insulation properties by containing the (meth)acrylate compound.

Even if a (meth)acrylate compound is contained in a sealing film, the sealing films of Comparison Examples 2 and 3 containing (meth)acrylate compound wherein n (number of ethyleneoxy group) is 3, the sealing films of Comparison Examples 4-6 containing (meth)acrylate compound having no ethyleneoxy group, and the sealing films of Comparison Example 7 containing (meth)acrylate compound having acryloyl group only on one end, show volume intrinsic resistivities of less than of 13.0, and hence do not indicate effect suppressing reduction of electrical insulation properties.

The above-mentioned results reveal that the use of the (meth)acrylate compound of the formula (I) suppresses the reduction of electrical insulation properties brought about by the inclusion of colorant.

Further, in the case the (meth)acrylate compound of the formula (I) is contained in an amount of 1.5 parts by weight based on 100 parts by weight of EVA, the formulation is kneaded with a little difficulty to show inferior processing property. Thus in view of processing properties, the content of the (meth)acrylate compound of the formula (I) is more preferably in the range of 0.1 to 1.0 part by weight based on 100 parts by weight of EVA

### Industrial Applicability

The present invention makes it possible to provide a solar cell having more high electric generation efficiency.

### Description of the Reference Numbers

- 11:: Transparent front side protection material
- 12:: Backside protection material
- 13A:: Front side sealing film
- 13B:: Backside sealing film
- 14:: Photovoltaic elements

## Claims

1. A solar cell sealing film comprising an ethylene-polar monomer co-polymer, a crosslinker and titanium dioxide as a colorant,
which further contains a (meth)acrylate compound represented by the following formula (I): 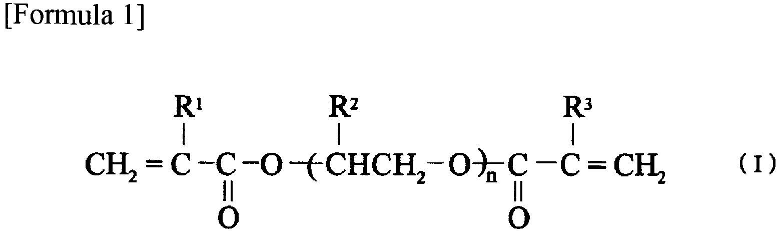 in which R¹, R² and R³ represent H or CH₃, and n is an integer of 9 to 14.

2. A solar cell sealing film as defined in claim 1, wherein R² of the formula (I) represents H.

3. A solar cell sealing film as defined in claim 1 or 2, wherein the (meth)acrylate compound is contained in an amount of 0.1 to 1 part by weight based on 100 parts by weight of the ethylene-polar monomer copolymer.

4. A solar cell sealing film as defined in any of claims 1 to 3, wherein the crosslinker is an organic peroxide.

5. A solar cell sealing film as defined in any of claims 1 to 4, wherein the ethylene-polar monomer copolymer is an ethylene-vinyl acetate copolymer.

6. A solar cell comprising a transparent front side protection material (11), a backside protection material (12) and photovoltaic elements (14) sealed there between by a sealing film (13A/13B), these being combined with each other by crosslinking of the sealing film,
wherein at least the sealing film between the backside protection material (12) and the photovoltaic elements (14) is the solar cell sealing film as defined in any of claims 1 to 5.

## Patentansprüche

1. Solarzellendichtungsfilm umfassend ein Ethylen-polares Monomer-Copolymer, ein Vernetzungsmittel und Titandioxid als Farbmittel,
der ferner eine (Meth)acrylatverbindung enthält, die durch folgende Formel (I) dargestellt ist: 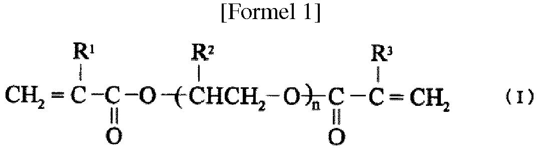 wobei R¹, R² und R³ H oder CH₃ darstellen und n eine ganze Zahl von 9 bis 14 ist.

2. Solarzellendichtungsfilm wie in Anspruch 1 definiert, wobei R² der Formel (I) H darstellt.

3. Solarzellendichtungsfilm wie in Anspruch 1 oder 2 definiert, wobei die (Meth)acrylatverbindung in einer Menge von 0,1 bis 1 Gewichtsteilen, auf 100 Gewichtsteile des Ethylen-polaren Monomer-Copolymers bezogen, enthalten ist.

4. Solarzellendichtungsfilm wie in einem der Ansprüche 1 bis 3 definiert, wobei das Vernetzungsmittel ein organisches Peroxid ist.

5. Solarzellendichtungsfilm wie in einem der Ansprüche 1 bis 4 definiert, wobei das Ethylen-polare Monomer-Copolymer ein Ethylen-Vinylacetat-Copolymer ist.

6. Solarzelle umfassend ein transparentes Vorderseitenschutzmaterial (11), ein Rückseitenschutzmaterial (12) und photovoltaische Elemente (14), die dazwischen durch einen Dichtungsfilm (13A/13B) abgedichtet sind, wobei diese miteinander durch Vernetzen des Dichtungsfilms kombiniert sind,
wobei mindestens der Dichtungsfilm zwischen dem Rückseitenschutzmaterial (12) und den photovoltaischen Elementen (14) der Solarzellendichtungsfilm, wie in einem der Ansprüche 1 bis 5 definiert, ist.

## Revendications

1. Film d'étanchéité pour pile solaire comprenant un copolymère d'éthylène-monomère polaire, un agent de réticulation et du dioxyde de titane comme colorant,
qui contient en outre un composé (méth)acrylate représenté par la formule suivante (I): 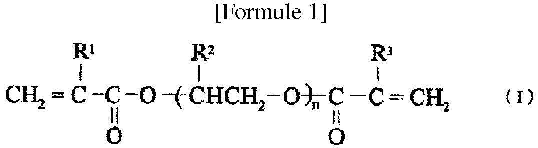 dans laquelle R¹, R² et R³ représentent H ou CH₃, et n est un nombre entier d'une valeur de 9 à 14.

2. Film d'étanchéité pour pile solaire tel que défini selon la revendication 1, où R² de la formule (I) représente H.

3. Film d'étanchéité pour pile solaire tel que défini selon la revendication 1 ou 2, où le composé (méth)acrylate est contenu en une quantité de 0,1 à 1 partie en poids sur la base de 100 parties en poids du copolymère d'éthylène-monomère polaire.

4. Film d'étanchéité pour pile solaire tel que défini selon l'une quelconque des revendications 1 à 3, où l'agent de réticulation est un peroxyde organique.

5. Film d'étanchéité pour pile solaire tel que défini selon l'une quelconque des revendications 1 à 4, où le copolymère d'éthylène-monomère polaire est un copolymère d'éthylène-acétate de vinyle.

6. Pile solaire comprenant un matériau transparent de protection de face avant (11), un matériau de protection de face arrière (12) et des éléments photovoltaïques (14) hermétiquement scellés entre eux par un film d'étanchéité (13A/13B), ceux-ci étant combinés les uns avec les autres par la réticulation du film d'étanchéité,
où au moins le film d'étanchéité entre le matériau de protection de face arrière (12) et les éléments photovoltaïques (14) est le film d'étanchéité pour pile solaire tel que défini selon l'une quelconque des revendications 1 à 5.
